Europäisches Patentamt

European Patent Office

Office européen des brevets

(11) Publication number: **0 167 391**
**B1**

(12) # EUROPEAN PATENT SPECIFICATION

(45) Date of publication of patent specification: **09.05.90**

(51) Int. Cl.⁵: **H 01 L 21/263**, H 01 L 21/20

(21) Application number: **85304719.9**

(22) Date of filing: **02.07.85**

(54) **Method of manufacturing semiconductor devices.**

(30) Priority: **02.07.84 JP 137583/84**

(43) Date of publication of application:
**08.01.86 Bulletin 86/02**

(45) Publication of the grant of the patent:
**09.05.90 Bulletin 90/19**

(84) Designated Contracting States:
**FR GB**

(56) References cited:
**EP-A-0 071 471**

**APPLIED PHYSICS LETTERS, vol. 41, no. 4, 15th August 1982, pages 346-347, American Institute of Physics, New York, US; J.P. COLINGE et al.: "Use of selective annealing for growing very large grain silicon on insulator films"**

**INTERNATIONAL ELECTRON DEVICES MEETING, 13th - 15th December 1982, San Francisco, pages 420-423, IEEE; T.I. KAMINS: "MOS transistors in beam-recrystallized polysilicon"**

(73) Proprietor: **SHARP KABUSHIKI KAISHA**
**22-22 Nagaike-cho Abeno-ku**
**Osaka 545 (JP)**

(72) Inventor: **Kakimoto, Seizo**
**Akebono-ryo 201 2613-1 Ichinomoto-cho**
**Tenri-shi Nara-ken (JP)**
Inventor: **Kudo, Jun**
**B2-402 Nakatomigaoka 1-chome**
**Nara-shi Nara-ken (JP)**
Inventor: **Koba, Masayoshi**
**1066-20 Shichijyonishimachi 1-chome**
**Nara-shi Nara-ken (JP)**

(74) Representative: **Wright, Peter David John et al**
**R.G.C. Jenkins & Co. 26 Caxton Street**
**London SW1H 0RJ (GB)**

(56) References cited:

**EXTENDED ABSTRACTS, vol, 83-1, May 1983, pages 574-575, abstract no 374, Pennington, N.J., US; Y. HAYAFUJI et al.: "Lateral epitaxial growth of Si over SiO2 through strip electron-beam irradiation"**

Courier Press, Leamington Spa, England.

(56) References cited:

PATENT ABSTRACTS OF JAPAN, vol. 7, no. 251
(E-209)1396r, 8th November 1983; & JP-A-58
139 423 (FUJITSU K.K.) 18-08-1983

MICROELECTRONICS JOURNAL, vol. 14, no. 6,
November-December 1983, pages 74-81, Benn
Electronics Publications Ltd, Kirkcaldy, GB; T.
INOUE et al.: "Electron-beam recrystallised
polysilicon on silicon dioxide"

PATENT ABSTRACTS OF JAPAN, vol, 9, no. 225
(E-342)1948r, 11th September 1985; & JP-A-60
83 322 (SONY K.K.) 11-05-1985

## Description

The present invention relates to a method of manufacturing semiconductor devices, and more particularly to a method of manufacturing such semiconductor devices, in which crystallization of either an amorphous or polycrystalline thin film is promoted by melting and recrystallizing the said thin film by radiating energy beams such as electron beams so that the recrystallized thin film can eventually grow into a monocrystalline configuration.

Recently, a variety of research has been intensively conducted to develop a method for effectively applying monocrystalline thin films comprised of either amorphous or polycrystalline material to the substrate of semiconductors. However, none of the conventional methods can effectively provide enough of an area to allow the growth of monocrystals, and such a problem prevents manufacturers from adequately designing needed electronic circuits.

In the light of such disadvantages that are still present in conventional techniques in conjunction with the manufacture of semiconductor devices and which are described above, the present invention aims at providing a useful method of manufacturing such monocrystals that can securely eliminate those disadvantages mentioned above, easily monocrystallize either amorphous or polycrystalline thin film, and significantly expands the monocrystalline area when compared to any of the conventional methods.

Methods of forming monocrystals from films of amorphous or polycrystaline material by radiation with various forms of energy beams or by providing differential energy absorption in said films resulting in a temperature gradient, have been described in EP—A—0 071 471 and in an article by J. P. Colinge et al in Applied Physics Letters, Volume 41, No. 4, 15th August 1982, pages 346—347, the teaching of these documents forms the first part of claim 1.

According to the invention there is provided a method of producing a film of monocrystalline material from an amorphous polycrystalline film of material comprising the steps of partially covering the amorphous or polycrystalline film with at least another material film so that when irradiated with energy beams there is differential energy absorption in the amorphous or polycrystalline film allowing the formation of a crystal at an area of lower energy absorption and the growth of a monocrystalline structure therefrom, characterised in that an insulating layer is disposed on the amorphous or polycrystalline material and a film of barrier material which resists the transmission of energy therethrough is disposed on the insulating layer, so that the barrier material partly covers the insulating layer, the growth of the monocrystalline structure starting in a portion of the amorphous or polycrystalline material below that part of the insulating layer covered by the barrier material.

In order that the present invention may be better understood a detailed description of an embodiment thereof will be given hereinbelow, by way of example, and with reference to the accompanying drawings wherein:

Figure 1 is a sectional view of a substrate for forming a monocrystalline structure according to the invention;

Figure 2 is a diagram showing the temperature distribution while the annealing process is underway;

Figure 3 is a sectional view of a substrate for explaining a recrystallization process according to a preferred embodiment of the present invention;

Figure 4 is a sectional view of a substrate according to another preferred embodiment of the present invention.

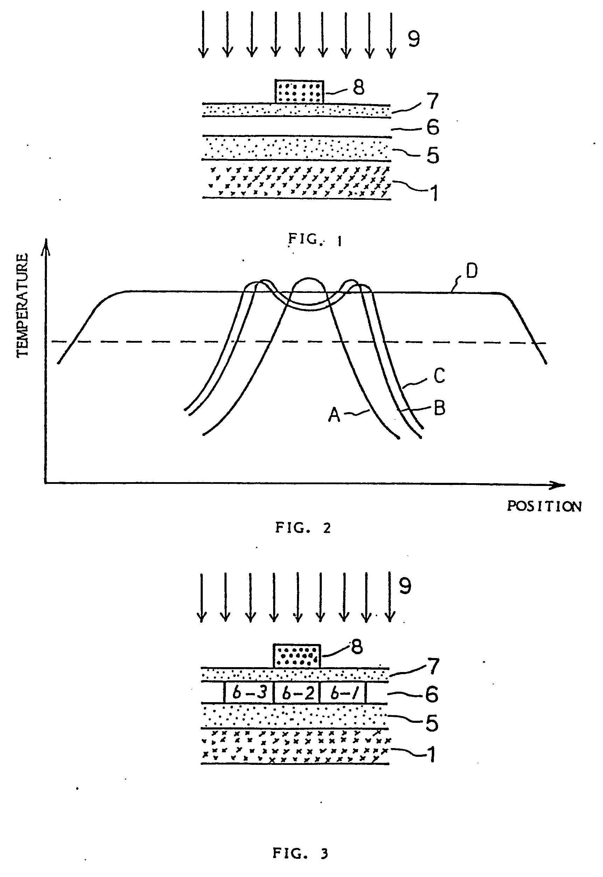

Referring now to the accompanying drawings, one of the preferred embodiments of the present invention is described below. This embodiment comprises the following steps. First, the non-monocrystallizable thin film is covered with a relatively thin insulation film functioning as a protection film, followed by the production of a substrate by laying up a piece of high-melting point metal thin film comprised of molybdenum (Mo) or tungsten (W) formed, for example, in a strip-shape having a width narrower than the diameter of electron beams in a position close to the area where the nucleus is generated when this metal film is developed into a monocrystalline state. Next, by radiating electron beams onto the prepared substrate, the bare portion of either the amorphous or polycrystalline thin film without coverage of the high-melting point metal film is directly heated via the insulation film. Conversely, the high-melting point metal film covering either the amorphous or polycrystalline thin film absorbs energy from the incident electron beams, thus causing heat to be generated, which then heats this film via the metal film. As a result, an ideal temperature distribution suited to the growth of such a monocrystalline substance is realized, where the centre of the position of the molten substrate can always bear a temperature lower than the peripheral portions in both cases while the melting is underway by means of incident electron beams and when the molten substance is again crystallized into monocrystals. Figure 1 is a sectional view of the substrate reflecting one of the preferred embodiments of the present invention. Referring now to Figure 1, an insulation film 5, composed of either $SiO_2$ or $Si_3N_4$, is formed on the surface of substrate 1 composed for example, of silicon. Either amorphous or polycrystalline silicon film 6 needed for monocrystallization is then formed on the surface of the insulation film 5, and, in addition, another insulation film 7, serving as protection film, composed of either $SiO_2$ or $Si_3N_4$ is also formed on the surface of either amorphous or polycrystalline silicon film 6. In addition, a piece of high-melting point metal film 8 comprised of molybdenum (Mo) or tungsten (W) featuring a significantly large electron-inhibitive function and high electron reflection rate are provided on the surface of the insulation film 7. Such a high-melting point thin film 8 is arranged in a belt-shaped pattern, while the width of this belt is regulated at approx. 10 to 20 micron meters, being narrower than the diameter of the incident electron beams.

When annealing such a substrate by radiating electron beams containing gaussian energy distribution characteristics, and a high-melting point thin film 8 not being formed, since the periphery of the dissolved portion absorbs an amount of energy less than the center position, as shown in the curve A of Figure 2, the peripheral temperature remains lower than that at the center position. As a result, a nucleus is generated from polycrystalline silicon which is present in the peripheral portions during the recrystallization period, thus allowing polycrystals to grow. Therefore, in order to adequately promote the growth of monocrystals, it is necessary to realize an energy distribution such that the temperature in the center position is lower than that of the peripheral portions when recrystallizing the molten substance. This causes the nucleus to be generated in the center of the molten area and allows monocrystals to grow without using polycrystalline silicon in the peripheral portions. Thus, in this preferred embodiment, a high-melting point thin film 8 is formed.

The incident electron beams directly heat the non-monocrystallizable silicon film 6 on both sides of the belt-shaped high-meltpoint metal film 8 when processing the substrate made in a configuration as described in Fig. 1. However, since the high-melting point metal film 8 effectively reflects and inhibits electrons, the layer portion beneath this film 8 causes the energy of the incident electron beams to decrease through the reflection effect, which is then all absorbed by this film 8, thus causing this film 8 to raise its own temperature. The elevated temperature is then led to amorphous or polycrystalline silicon film 6. This means that the high-melting point metal film 8 adequately inhibits the non-monocrystallizable silicon film 6 from raising its own temperature, thus resulting in a temperature distribution such that the center position constantly presents a lower temperature than the periphery as shown in curve B of Figure 2. As a result, this system provides a nucleus generating position suited for the growth of monocrystals.

The high-melting point metal film 8 also prevents electron beams from reaching the portion that should be directly monocrystallized, thus effectively preventing the electron transmission path of the monocrystalline layer from damage. The thickness of the high-melting point metal film 8 featuring the electron inhibiting characteristics, i.e., electron absorbent characteristics, is provided so that it is greater than the flight range of electron beams and enough to absorb all the energy of electron beams into the film substance.

For example, when molybdenum (Mo) is used for making up the metal film 8 and then annealed by applying 10 KV of the acceleration voltage of electron beams, since each electron beam is assumed to have about 300 nanometers of flight range, this metal film 8 should be provided with a greater thickness. The thickness of the molybdenum film 8 is then determined within a range of approx. 1000 through 1,500 nanometers in consideration of the effect of lowering the temperature during the thermal conduction through the molybdenum film 8.

The insulation film 7 covering the silicon film 6 provides a variety of effects including the effect of delaying the thermal conduction from the high-melting point metal film 8 that absorbs electron beams, the effect of preventing the silicon film 6 from incurring damage caused by directly incident electron beams, and the effect of preventing possible strain otherwise caused by direct contact between the silicon film 6 and the electron absorbing high-melting point metal film 8. To quickly lower the metal-film generating high temperature in the layer portion beneath the metal film 8 by means of thermal conduction through the silicon film 6, the insulation film 7 is approx. 400 to 600 nanometers thick.

Figure 3 is the sectional view of the substrate showing the recrystallization process in another of the preferred embodiments of the present invention. Referring now to Figure 3, assume that electron beams 9 containing approx. 5 through 10 KV of acceleration voltage and a Gaussian energy distribution denoted by approx. 100 through 200 micron meters of the beam diameter are radiated onto the prepared layer-substrate so that the center of the electron beams can correctly hit the center position of the high-melting point metal film 8, then electron beams 9 penetrate into the non-crystallizable silicon film 6 through the insulation film 7, and as a result, the temperature in the bare portions 6—1 and 6—3 of the said silicon film 6 (i.e. without coverage of the electrom beam absorbing metal film 8) rises. Conversely, part of the incident electron beams reflects against the portion 6—2 covered by the electron beam absorbing metal film 8, whereas the remaining electron beams are all absorbed by the metal film 8, thus causing the temperature of this film to rise. As a result, the generated heat is conducted to the non-crystallizable silicon film 6 through the insulation film 7. During this period, the temperature in the portion 6—2 just below the electron-beam absorbing metal film 8 becomes lower than the peripheral portions or bare portions 6—1 and 6—3 in the boundary area due to loss of energy caused by reflection of electron beams from the electron absorbing metal film 8 and the lowered temperature due to thermal transfer through the said metal film 8 and the insulation film 7. As a result, as shown in Curve C of Figure 2, the temperature remains low in the centre areas whereas it remains high in the peripheral areas. While such a temperature distribution is present, the nucleus is generated in the center area 6—2 when the molten solution coagulates. The nucleus then develops so that a monocrystalline thin film can be eventually formed. Thus, the above described annealing process eventually generates monocrystals. After completing the annealing and subsequent processes described, the high-melting point metal thin film 8 and the insulation film 7 are both removed by an etching process, and finally, the monocrystalline area is processed by photolithography so that a state suited for the manufacture of semiconductive elements can be generated.

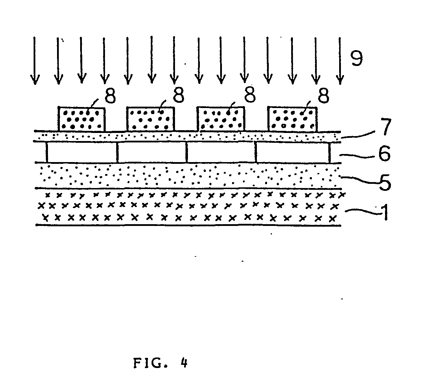

Figure 4 is the sectional view of the substrate showing another preferred embodiment of the present invention. This represents the configuration of the substrate available for generating a plurality of monocrystalline areas 6, --- connected to each other in a common thin film by an annealing process that uses pseudo-linear electron beams. As was done in the foregoing preferred embodiment, this embodiment causes the stripe-shaped high-melting point metal film 8 to be formed in the line-and-space format by providing approx. 10 through 20 micron meters of the line width and approx. 5 micro meters of space, respectively. The pseudo-linear electron beams are formed by causing electron spot beams to deflect perpendicularly to the scanning direction in a width ranging from approx. 300 through a maximum of 600 micro meters by applying triangular waveform AC voltage (having approx. 100 through 300 kHz of the triangular waveform frequencies), where the said electron spot beams have a Gaussian energy distribution denoted by approx. 100 through 200 micron meters of the beam diameter using approx. 1.8 through 2.0 mA of the beam current and approx. 5 through 10 KV of the acceleration voltage, respectively. Formation of the deflected pseudo-linear electron beams realizes such an ideally uniform temperature distribution featuring the broad width shown by the solid line D of Figure 2. A plurality of monocrystalline areas is formed by simultaneously annealing the area containing a plurality of stripes of the metal film 8 by applying the pseudo-linear electron beams. Since the width of the monocrystalline areas are connected to each other by setting the width of the line and space at those values described earlier, monocrystalline areas are not always formed in directions identical to each other. Thus, boundary layers are formed in the border of monocrystalline areas. Applying this, the stripe-shaped monocrystalline areas being closely connected to each other can be formed by several hundred micrometers of the width. In addition, it is also possible to form beltlike monocrystals covering the whole of the needed area by radiating the partially overlapped pseudo-linear electron beams.

Also, by applying the layer pattern shown in Figure 4, stripe-shaped monocrystaline areas connected to each other can be generated by radiating the partially overlapped electron spot beams. However, the crystallization effect may not be properly provided due to the disturbed temperature distribution when the electron spot beams incorrectly pass through the center of the stripe of the metal film 8, or due to recurrence of the dissolution of the monocrystallized areas being adversely affected by radiation of the overlapped electron spot beams.

To prevent this, it is suggested that application of the pseudo-linear electron beams could provide better stability and greater dimensions of the monocrystalline area than those offered by the electron spot beams. In addition, it is possible to provide a greater throughput due to the greater range of annealing operation available. If any damage that may be incurred by the high-melting point metal film 8 due to radiation of electron beams is a critical problem, an insulation film composed of $SiO_2$ or $Si_3N_4$ may also be laid upon the surface of the metal film 8 for protection.

In the preferred embodiments of the present invention described above, high-melting point metals such as molybdenum (Mo) or tungsten (W) are provided. However, the present invention doesn't define the use of these elements, but the high-melting point element must be capable of effectively absorbing and inhibiting the attack of electron beams without allowing their permeance. For example, a relatively thick polysilicon film may also be provided.

As is clear from the foregoing description, when recrystallizing the melted amorphous or polycrystalline thin film into monocrystals after completing annealing using electron beams, compared to any of the conventional methods, the preferred embodiments of the present invention can safely realize monocrystallization of the semiconductive substrate by sharply minimizing the possibility of damage to the under-layer elements by the presence of the electron transmission line while installing monocrystalline layers and/or circuit elements using a layer structure. In addition, the preferred embodiments can better expand the monocrystalline area than any of the conventional methods.

The melting points of tungsten (W), molybdenum (Mo) are about 3387 degrees C and about 2160 degrees C, respectively. In place of tungsten and molybdenum, tantalum (Ta) or zirconia (Zr) may be used in the present invention. The melting points of tantalum and zirconium are about 2996 degrees C and about 1852 degrees C, respectively.

Also, the electron reflection ratios of tungsten, molybdenum, tantalum and zirconia are about 0.458, about 0.421, about 0.511, and about 0.417, respectively.

The invention being thus described, it will be obvious that the same may be varied in many ways. Such variations are not to be regarded as a departure from the scope of the invention, and all such modifications are intended to be included within the scope of the following claims.

## Claims

1. A method of producing a film of monocrystalline material from an amorphous or polycrystalline film of material (6) comprising the steps of disposing on the amorphous or polycrystalline film (6) layer means which causes differential energy absorption in the amorphous or polycrystalline film (6) when it is irradiated with energy beams (9) through the layer means, allowing the formation of a crystal at an area of lower energy absorption and the growth of a monocrystalline structure therefrom, characterised in that the layer means comprises an insulating layer (7) disposed on the amorphous or polycrystalline material (6) and a film of barrier material (8) disposed on and partly covering the insulating layer (7), which film resists the transmission of energy therethrough, the growth of the monocrystalline structure starting in a portion of the amorphous or polycrystalline material (6) below that part of the insulating layer (7) covered by the barrier metal (8).

2. A method according to Claim 1 wherein said barrier material is a high melting point metal and is disposed on the insulating layer in one or more elongate substantially parallel strips.

3. A method according to Claim 2 wherein said energy beams are scanned across the surface of the insulating layer in a direction substantially parallel to the metal strip or strips so that the monocrystalline structure grows in an elongate configuration below the or each metal strip and substantially parallel thereto.

4. A method according to Claim 2 or Claim 3 wherein the or each metal strip has a width narrower than the width of the energy beams.

5. A method according to any of Claims 2 to 4 wherein the energy beams are electron spot beams each having a Gaussian energy distribution profile.

6. A method according to Claim 5 wherein each of said electron spot beams has a diameter of 100 to 200 micrometers.

7. A method according to Claim 5 or Claim 6 wherein the high melting point is disposed as a plurality of strips and a triangular waveform AC voltage is applied to repeatedly deflect the electron spot beams at high speed in a direction substantially perpendicular to the scanning direction to create a pseudo-linear electron beam.

8. A method according to Claim 7 wherein said electron spot beams are deflected by 300 to 600 micrometers.

9. A method according to Claim 7 or Claim 8 wherein said metal strips are spaced at intervals of 5 micrometers.

10. A method according to any of Claims 2 to 9 wherein each of said metal strips has a width of 10 to 20 micrometers.

11. A method according to any preceding claim wherein the energy beams have an accelerating voltage of 5 to 10 KY.

12. A method according to any preceding claim wherein said insulating layer is $SiO_2$ or $Si_3N_4$.

## Patentansprüche

1. Verfahren zur Herstellung eines Films aus einkristallinem Material aus einem Film (6) aus amorphem oder polykristallinem Material durch Aufbringen einer Schicht auf den amorphen oder polykristallinen Film (6), die eine unterschiedliche Energieabsorption in dem amorphen oder polykristallinen Film (6) bei dem Bestrahlen des Films mit Energiestrahlung (9) durch die Schicht bewirkt, so daß die Bildung eines Kristalls in einem Bereich geringer Energieabsorption und daraus das Wachstum einer einkristallinen Strukur ermöglicht wird, dadurch gekennzeichnet, daß die Schicht eine auf dem amorphen oder polykristallinen Material (6) angeordnete isolierende Schicht (7) und einen Film aus einem Sperrmaterial (8), der auf der isolierenden Schicht (7) angeordnet ist und diese teilweise bedeckt, umfaßt, welcher Film die Engergieübertragung verhindert, so daß das Wachstum der einkristallinen Struktur in einem Bereich des amorphen oder polykristallinen Materials (6) unterhalb jenes Bereiches der isolierenden Schicht (7) beginnt, der von dem Sperrmaterial (8) bedeckt ist.

2. Verfahren nach Anspruch 1, worin das Sperrmaterial ein Metall mit einem hohen Schmelzpunkt ist, welches auf der isolierenden Schicht in Form eines oder mehrerer länglicher, im wesentlichen paralleler Streifen angeordnet ist.

3. Verfahren nach Anspruch 2, worin die Energiestrahlen in einer Richtung im wesentlichen parallel zu den Metallstreifen oder dem Metallstreifen über die Oberfläche der isolierenden Schicht geführt werden, so daß die einkristalline Struktur in länglicher Konfiguration unterhalb des oder eines jeden Metallstreifens und im wesentlichen parallel dazu wächst.

4. Verfahren nach Anspruch 2 oder 3, worin jeder Metallstreifen eine Breite aufweist, welche geringer ist als die Breite der Energiestrahlen.

5. Verfahren nach einem der Ansprüche 2 bis 4, worin die Energiestrahlen gebündelte Elektronenstrahlen sind, die jeweils ein Energieprofil mit einem Gaußschen Verteilungsprofil aufweisen.

6. Verfahren nach Anspruch 5, worin der gebündelte Elektronenstrahl einen Durchmesser von 100 bis 200 Mikrometer aufweist.

7. Verfahren nach Anspruch 5 oder 6, worin das Metall mit hohem Schmelzpunkt in Form einer Vielzahl von Streifen aufgebracht ist und eine Wechselspannung mit dreieckiger Wellenform angelegt wird, um den gebündelten Elektronenstrahl wiederholt mit hoher Geschwindigkeit in einer Richtung im wesentlichen senkrecht zu der Abtastrichtung abzulenken und damit einen pseudo-linearen Elektronenstrahl zu erzeugen.

8. Verfahren nach Anspruch 7, worin der gebündelte Elektronenstrahl um 300 bis 600 Mikrometer abgelenkt wird.

9. Verfahren nach Anspruch 7 oder 8, worin die Metallstreifen in Abständen von etwa 5 Mikrometer angeordnet sind.

10. Verfahren nach einem der Ansprüche 2 bis 9, worin die Metallstreifen eine Breite von 10 bis 20 Mikrometer aufweisen.

11. Verfahren nach einem der vorhergehenden Ansprüche, worin die Energiestrahlen eine Beschleunigungsspannung von etwa 5 bis 10 kV aufweisen.

12. Verfahren nach einem der vorhergehenden Ansprüche, worin die isolierende Schicht aus $SiO_2$ oder $Si_3N_4$ besteht.

**Revendications**

1. Procédé pour fabriquer une pellicule d'un matériau monocristallin au moyen d'une pellicule amorphe ou polycristalline d'un matériau (6), incluant les étapes consistant à disposer, sur la pellicule amorphe ou polycrystalline (6), un moyen en forme de couche qui provoque une absorption d'énergie différentielle dans la pellicule amorphe ou polycristalline (6) lorsqu'elle est irradiée par des faisceaux d'énergie (9) traversant les moyens en forme de couche, en permettant la formation d'un cristal dans une zone de faible absorption de l'énergie et la croissance d'une structure monocristalline à partir de cette zone, caractérisé en ce que le moyen en forme de couche comprend une couche isolante (7) située sur le matériau amorphe ou polycristallin (6) et une pellicule d'un matériau formant barrière (8) disposée sur et recouvrant partiellement la couche isolante (7), laquelle pellicule s'oppose à la transmission d'une énergie à travers elle, la croissance de la structure monocristalline commençant dans une partie du matériau amorphe ou polycristallin (6), située au-dessous de la partie de la couche isolante (7), qui est recouverte par le matériau formant barrière (8).

2. Procédé selon la revendication 1, dans lequel ledit matériau formant barrière est en métal à point de fusion élevé et est disposé sur la couche isolante sous la forme d'une ou de plusieurs bandes allongées sensiblement parallèles.

3. Procédé selon la revendication 2, dans lequel lesdits faisceaux d'énergie balayent la surface de la couche isolante dans une direction sensiblement parallèle à la ou aux bandes métalliques de sorte que la croissance de la structure métallique s'effectue selon une configuration allongée au-dessous de la ou de chaque bande métallique et sensiblement parallèlement à cette dernière.

4. Procédé selon la revendication 2 ou 3, dans lequel la ou chaque bande métallique possède une largeur inférieure à la largeur des faisceaux d'énergie.

5. Procédé selon l'une quelconque des revendications 2 à 4, dans lequel les faisceaux d'énergie sont des faisceaux en forme de spots électroniques possédant chacun un profil de distribution en énergie gaussien.

6. Procédé selon la revendication 5, dans lequel chacun desdits faisceaux en forme de spots électroniques possède un diamètre de 100 à 200 microns.

7. Procédé selon la revendication 5 ou 6, dans lequel le métal à point de fusion élevé est disposé sous la forme d'une pluralité de bandes, et une tension alternative possédant un forme d'onde triangulaire est appliquée de manière à faire dévier, d'une manière répétée, les faisceaux en forme de spots électroniques à grande vitesse dans une direction sensiblement perpendiculaire à la direction de balayage de manière à créer un faisceau d'électrons pseudo-linéaire.

8. Procédé selon la revendication 7, dans lequel lesdits faisceaux en forme de spots électroniques sont déviés sur 300 à 600 microns.

9. Procédé selon la revendication 7 ou 8, dans lequel lesdites bandes métalliques sont séparées par des intervalles égaux à environ 5 microns.

10. Procédé selon l'une quelconque des revendications 2 à 9, dans lequel lesdites bandes métalliques possèdent une largeur de 10 à 20 microns.

11. Procédé selon l'une quelconque des revendications précédentes, dans lequel les faisceaux d'énergie possèdent une tension accéleratrice de 5 à 10 kV.

12. Procédé selon l'une quelconque des revendications précédentes, dans lequel ladite couche isolante est formée de $SiO_2$ ou de $Si_3N_4$.

EP 0 167 391 B1

FIG. 1

FIG. 2

FIG. 3

1

FIG. 4